# EUROPEAN PATENT APPLICATION

(11) **EP 2 662 694 A1**
(43) Date of publication of application: **13.11.2013**
(21) Application number: 12167233.1
(22) Date of filing: 09.05.2012
(51) Int. Cl.: G01R 1/04, G01R 31/28

(54) **Chip socket**

(71) Applicant: Dialog Semiconductor GmbH, 73230 Kirchheim (DE)
(72) Inventor: Marschalkowski, Eric, 82110 Germering (DE); Stadtmann, Karl, 82110 Germering (DE)
(74) Representative: MERH-IP Matias Erny Reichl Hoffmann

(57) **Abstract**

The present document relates to chip sockets. In particular, the present document relates to chip sockets which are particularly adapted for testing integrated circuit chips. A chip socket (100) adapted for carrying an integrated circuit chip (200) is described. The chip socket (100) comprises a plate (101) adapted for mounting onto a front side of a printed circuit board (300), referred to as a PCB; a plurality of electrical PCB connectors (102) in a first area on a backside of the plate (101); wherein the plurality of electrical PCB connectors (102) is adapted for electrically connecting the chip socket (100) to a corresponding plurality of connectors on the PCB (300); and a corresponding plurality of chip connectors (103) on a front side of the plate (101); wherein the plurality of chip connectors (103) is electrically connected to the plurality of electrical PCB connectors (102), respectively; wherein the plurality of chip connectors (103) is adapted for connecting the chip socket (100) to a corresponding plurality of connectors (201) of the integrated circuit chip (200); wherein the plate (101) comprises a recess (104) at its backside between the first area and an edge (106) of the plate (101).

## Description

The present document relates to chip sockets. In particular, the present document relates to chip sockets which are particularly adapted for testing integrated circuit chips.

For testing an integrated circuit (IC) chip which is to be placed at a designated position on a printed circuit board (PCB), a chip socket (instead of the IC chip) is typically placed at the designated position on the PCB and the IC chip is placed in the chip socket. This has the advantage that the IC chip can be easily replaced, in order e.g. to test different versions of the IC chip. The backside of the chip socket is typically mounted on the PCB and provides electrical connections to the PCB. The front side of the chip socket typically provides means for electrically connecting the IC chip to the electrical connectors of the PCB, e.g. with socket internal connections. Furthermore, the chip socket typically provides means for positioning and maintaining the IC chip at a predetermined position on the chip socket.

The chip socket typically requires a larger space on the PCB than the IC chip itself. This additional space is required e.g. for fixing the chip socket on the PCB and for providing appropriate means for positioning the IC chip on the chip socket. As a result, the PCB which is used for testing the IC chip has to reserve sufficient space for the mounting of the chip socket. In other words, the PCB which is used for testing the IC chip does not fully reflect the conditions under which the IC chip is used when being mounted directly onto the PCB. In yet other words, the test conditions of the IC chip do not fully correspond to the operational conditions of the IC chip, thereby reducing the correctness and reliability of the test results.

In particular, it has been observed by the inventors that test conditions using a chip socket instead of direct mounting the IC chip may lead to deteriorated test results which indicate a malfunctioning of the IC chip, whereas the IC chip actually works correctly under normal operational conditions (involving direct mounting). As a consequence, the test results which are obtained when using a chip socket are overly negative, thereby increasing the design and manufacturing costs of the IC chip. The present document addresses the above mentioned shortcomings of conventional chip sockets.

According to an aspect a chip socket adapted for carrying an integrated circuit (IC) chip is described. The IC chip may comprise one or more switches which are adapted to switch on and off a current. By way of example, the IC chip may comprise one or more switches for a switched mode power supply.

The chip socket is adapted for being mounted onto a printed circuit board. In particular, the socket comprises a plate, e.g. a bottom plate, adapted for mounting onto a front side of a printed circuit board (PCB). The plate may have a rectangular shape.

Furthermore, the socket comprises a plurality of electrical PCB connectors in a first area on a backside of the plate. The first area may comprise a center position of the plate. In particular, the first area may be centered around the center position of the plate. The plurality of PCB connectors may form an array (e.g. a rectangular array) and the first area may correspond to the array formed by the plurality of PCB connectors.

The plurality of electrical PCB connectors is adapted for electrically connecting the chip socket to a corresponding plurality of connectors on the PCB. The plurality of PCB connectors may be any one of: a land grid array, a ball grid array, a pm grid array, JPLL, CPLL, a pressure sensitive conductive foil.

Furthermore, the socket comprises a corresponding plurality of chip connectors on a front side of the plate. The plurality of chip connectors is electrically connected to the plurality of electrical PCB connectors, respectively. This means that each of the plurality of chip connectors is electrically connected to a corresponding one of the plurality of PCB connectors. By way of example, the plurality of chip connectors and the plurality of PCB connectors are implemented as a joint plurality of needles traversing the plate from the front side to the back side.

The plurality of chip connectors is adapted for connecting the chip socket to a corresponding plurality of connectors of the integrated circuit chip. As such, the plurality of connectors of the IC chip may be connected to the PCB via the plurality of chip connectors and the plurality of PCB connectors.

The plate comprises a recess at its backside between the first area and an edge of the plate. The recess may be positioned in the direct vicinity of an edge of the first area. In particular, the recess may be closer to an edge of the first area than to the edge of the plate. The recess may enclose the first area, i.e. the recess may be continuous and encircle the first area. By way of example, the recess may be a groove (e.g. a milling groove) within the backside of the plate. The plate may comprise a plurality of recesses, e.g. the plate may comprise a plurality of recesses which enclose the first area at different distances from the edge of the first area. The backside of the plate may be substantially flat (except for the recess and the plurality of PCB connectors comprised within the first area).

The recess may be adapted for accommodating an electrical component (e.g. a passive component such as a capacitance) mounted onto the front side of the PCB. In other words, the dimensions (width and/or depth) of the recess may correspond to the dimensions (width and/or height) of the electrical components which are to be accommodated within the recess.

The plurality of chip connectors may be any one of: a land grid array, a ball grid array, a pin grid array, JPLL, CPLL, a pressure sensitive conductive foil. In more general terms, the integrated circuit chip may have a standardized chip package, and the socket may be adapted to carry (and to interconnect) with the IC chip having such a standardized chip package.

The plurality of chip connectors on the front side of the plate may be positioned in the first area. In particular, the plurality of chip connectors and the plurality of PCB connectors may be positioned at the same position on the front side and the backside of the plate, respectively. As such, the plurality of chip connectors may mimic the plurality of connectors on the PCB. In an embodiment, the plate comprises a removable inset at the first area. The inset comprises the plurality of electrical PCB connectors on a backside of the inset and the plurality of chip connectors on a front side of the inset. As such, the socket may be adaptable to different chip packages by replacing the inset for a particular package type with another inset for another package type.

The chip socket may further comprise means for fixing the integrated circuit chip onto the front side of the plate such that the plurality of chip connectors is connected to the corresponding plurality of connectors of the integrated circuit chip, when the integrated circuit chip is fixed onto the front side of the plate. The fixing means may be adapted to apply a force onto the IC chip for maintaining the IC chip in the appropriate position within the socket. The force may be applied by use of one or more screws or by use of one or more clamps.

According to another aspect, a printed circuit board comprising a chip socket with any one or more of the features outlined in the present document is described.

It should be noted that the systems including its preferred embodiments as outlined in the present document may be used stand-alone or in combination with the other systems disclosed in this document. Furthermore, all aspects of the systems outlined in the present document may be arbitrarily combined. In particular, the features of the claims may be combined with one another in an arbitrary manner.

The invention is explained below in an exemplary manner with reference to the accompanying drawings, wherein
Fig. 1 illustrates a schematic side view of an example chip socket;
Fig. 2 illustrates a schematic bottom view (or back view) of an example chip socket; and
Fig. 3 illustrates a schematic top view (or front view) of a printed circuit board comprising a chip socket.

As outlined in the introductory section, integrated circuit (IC) chips are typically tested using a chip socket fixed onto a PCB. This allows the IC chips to be easily fixed and removed from the PCB, thereby allowing the testing of various versions or a series of the IC chips. It has been observed by the inventors that for certain conditions the test results which are obtained when testing an IC chip using a chip socket may be worse than the test results which are obtained when testing the IC chip which is directly mounted onto the PCB. In particular, it has been observed that when using switched mode power supplies, high voltages may be created at or within the IC chip when used in conjunction with a chip socket. These high voltages may affect the performance of the IC chip, e.g. cause a failure of the IC chip.

It is a finding of the inventors that the high voltages at or within the IC chip are created because as a result of the relatively large size of the chip socket, electronic components (e.g. a capacitance C) can only be positioned on the PCB at a relatively high distance from the IC chip itself. In particular, it has been observed that the relatively long electrical connection between the IC chip and an electronic component (e.g. the capacitance C) results in an equivalent series resistance (ESR) and an equivalent series inductance (ESL). In case of changes of the current on the electrical connection (e.g. in case of a transient current or in case of a ripple current of the switched mode power supply), the ESL lead to a voltage at the connector of or within the IC chip. This ESL induced voltage increases proportional to the length of the connection between the IC chip and the passive component (e.g. the capacitance C) on the PCB. Typical values for the ESL effect are about 1nH per 0.7 mm length of the electrical connection. It has been observed that variations in the current (dI/dt) lead to a voltage of about 1V per 1nH of ESL. This means that electrical connections of only a few mm may lead to significant voltages which may be high compared to the supply voltage (e.g. 4V) at the IC chip. This may be particularly relevant for IC chips which comprise one or more switches (e.g. for a switched mode power supply) and which generate ripple currents or transient currents with significant current edges.

In view of the ESL induced voltages, it is desirable to place the electrical components on the PCB which are (directly) linked to the IC chip as close as possible to the IC chip (even when using a chip socket). In other words, it is desirable to ensure that the ESL effects imposed on the IC chip during test conditions (i.e. using a chip socket) are identical to or as close as possible to the ESL effects imposed on the IC chip during operational conditions (i.e. when the IC chip is directly mounted onto the PCB).

A possible way to achieve this goal could be to place the electrical components (e.g. a passive component such as a capacitance C) at the backside of the PCB (while the chip socket is mounted onto the front side of the PCB). This requires a passage through the PCB e.g. through the use of stacked vias. Such vias are, however, relatively costly to implement. Furthermore, a complete passage through the PCB typically also leads to a relatively high distance of the passive component to the connector of the IC chip, thereby leading to unwanted ESL effects.

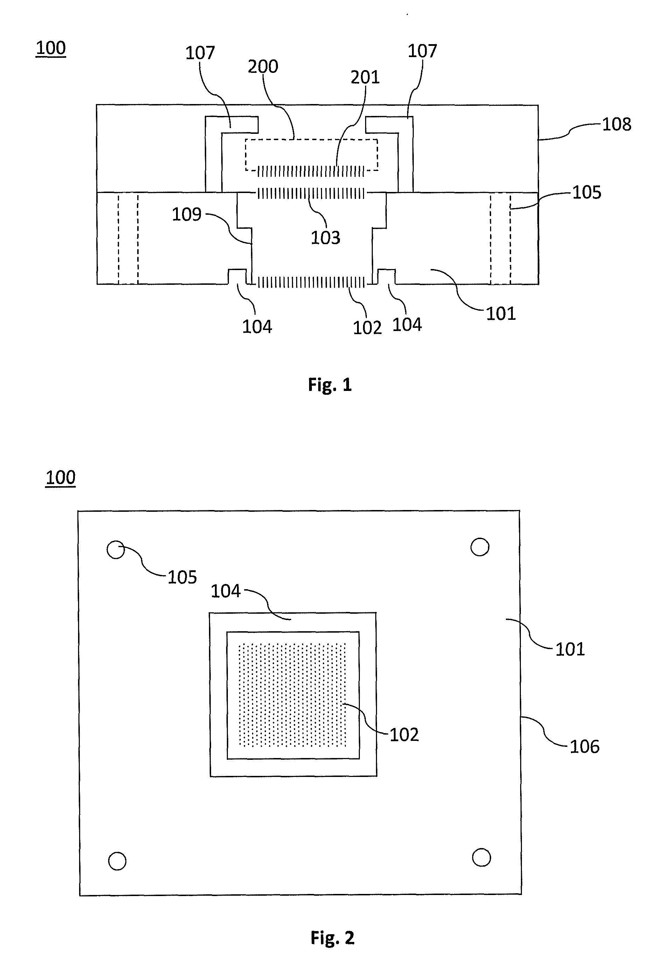

In the present document, it is proposed to adapt the chip socket such that electrical components can be placed in the direct vicinity of the IC chip, in particular in the direct vicinity of the connectors of the IC chip. Fig. 1 illustrates a schematic side view of an example chip socket 100. The chip socket 100 comprises a bottom plate 101 which is adapted to be mounted onto the front side of a PCB. For mounting purposes, the chip socket 100 may comprise fixing means 105 (e.g. holes 105 within the bottom plate 101 for screwing the chip socket 101 onto to the PCB).

The chip socket 100 comprises a plurality of PCB connectors 102 (e.g. an array of PCB connectors) at the backside of the bottom plate 101 (i.e. at the side which is facing the front side of the PCB, when the socket 100 is mounted onto the PCB). Each of the plurality of PCB connectors 102 is adapted to electrically connect with a corresponding one of a plurality of connectors on the PCB.

Furthermore, the socket 100 comprises a plurality of chip connectors 103 (e.g. an array of chip connectors) at the front side of the bottom plate 101 (opposite of the backside of the bottom plate 101). The plurality of chip connectors 103 is adapted to connect to a corresponding plurality of connectors 201 of an IC chip 200. mounted onto the chip socket 100. Each of the plurality of chip connectors 103 is electrically connected to a corresponding one of the plurality of PCB connectors 102, thereby electrically connecting the IC chip 200 to the PCB, when the IC chip 200 is fixed onto the socket 100. The plurality of PCB connectors may correspond to the plurality of chip connectors 103. In other words, the arrangement of the array of PCB connectors 102 may correspond to (may be identical to) the arrangement of the plurality of chip connectors 103.

In an example embodiment, the plurality ofPCB connectors 102 and the plurality of chip connectors 103 are implemented as a plurality of needles (or pins), wherein each needle forms one of the plurality of chip connectors 103 (at its front side) and the corresponding one of the plurality of PCB connectors 102 (at its backside). This means that each needle traverses the plate 101 of the socket 100 and forms a chip connector on its front side and a PCB connector at its backside. Each needle may be movably arranged to ensure an electrical connection between the chip 200 and the PCB when the chip 200 is mounted onto the socket 100. In particular, each needle may be moved and pressed towards the PCB when the chip 200 is mounted onto the socket 100.

The socket 100 (and in particular the plurality of chip connectors 103) is typically adapted to carry and to connect to a chip 200 having a particular standardized chip package. Example chip packages are a ball grid array (BGA), a pin grid array (PGA), a NBA (No Ball Array), a Quad Flat No Leads (QFN), a JPCC, an LCC (Lead Chip Carrier), CSP (Chip Scale Package) or a CPCC. In order to be adaptable to different chip packages, the socket 100 may comprise a removable inset 109. A particular inset 109 may be adapted to a particular chip package. As such, different insets 109 for different chip packages may be provided and the socket 100 may be adapted to a particular chip package by exchanging the inset 109.

The socket 100 may comprise fixing means 107 (e.g. one or more clamps) for positioning and maintaining the chip 200 at the appropriate position on the socket 100, wherein the appropriate position ensures the connection between each of the connectors 201 of the chip 200 with the corresponding chip connectors 103 of the socket 100. The fixing means 107 may apply a force onto the chip 200 in order to ensure a reliable electrical connection between corresponding ones of the plurality of connectors 103 and 201. The individual connectors of the connector arrays 103, 201 may be positioned at a distance of 0.3 to 0.5 mm, i.e. the pitch of the connectors 103, 201 may be 0.3 to 0.5 mm. It should be noted that distances and/or pitches in other value ranges may be possible. A typical number of connectors 103, 201 is several hundreds of (e.g. about 300) pins. This means that there is only very little tolerance for positioning the chip 200 onto the socket 100 (e.g. in the range of 0.2mm). Typically, the same tolerances apply to the positioning of the socket 100 onto the PCB.

In addition, the socket 100 may comprise a frame 108 enclosing the position of the socket 100 for placing the IC chip 200.

As outlined above, the dimensions of the socket 100 are typically significantly greater than the dimensions of the IC chip 200. This means that a PCB which is adapted to accommodate the socket 100 needs to reserve a larger space for the socket 100 than a PCB which is adapted to accommodate the IC chip 200 itself. Furthermore, this means that electrical components such as a capacitor C, which may be required at an output or input port of the IC chip 200, need to be placed on the PCB at a greater distance from the respective port of the chip 200, when using a socket 100. As already indicated, this may deteriorate the performance of the chip 200 under test conditions (when using a socket 100).

For this purpose, the socket 100 illustrated in Fig. 1 comprises one or more recesses 104 on the back side of the bottom plate 101. A recess 104 may be a groove, e.g. a milling groove. The dimensions of the recess 104 are adapted to accommodate one or more electrical components (e.g. a transistor or a passive component such as a capacitance) on the PCB, when the socket 100 is mounted onto the PCB. In other words, a recess 104 may have a depth and a width which is adapted to the height and the width of a corresponding electrical component on the PCB. The height and/or the width of an electrical component may be in the range of 0.5mm to 1mm. By way of example, the electrical component may be a capacitance from the 0201 up to the 0402 series. It should be noted, however, that the height and/or the width of an electrical component may be in a different range. The one or more recesses 104 may be positioned in the direct neighborhood of or in the direct vicinity of (or close to) the plurality of PCB connectors 102. This means that an electrical component on the PCB may be positioned at a reduced distance to a port of the IC chip 200 to which the electrical component is coupled. At the same time, it remains possible to mount the electrical component onto the front side of the PCB, thereby removing the needs for costly vias through the PCB.

Fig. 2 illustrates a schematic bottom view of an example socket 100. The example socket 100 comprises a continuous recess 104 which encloses the plurality of PCB connectors 102. The recess 104 may have a shape which matches the arrangement formed by the plurality of PCB connectors 102. In the illustrated example, the plurality of PCB connectors 102 forms a rectangular array and the recess 104 corresponds to a frame shaped groove around the rectangular array. It can be seen that the recess 104 is positioned in the direct vicinity of the plurality of PCB connectors 102 (e.g. as close as possible without impacting the function and stability of the PCB connectors 102). Typically, the recess 104 is positioned closer to an edge of the plurality of PCB connectors 102 than to the edge 106 of the socket 100.

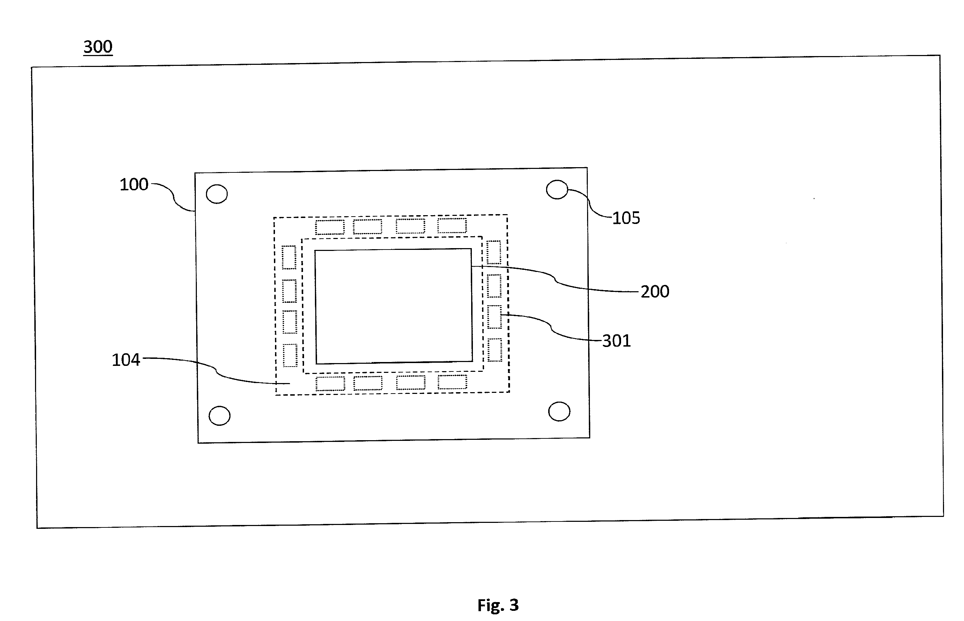

Fig. 3 illustrates a schematic top view of an example PCB 300 comprising a socket 100 on its front side. The socket 100 is mounted onto the PCB 300 using the fixing means 105 of the socket 100. Furthermore, Fig. 3 illustrates the recess 104 on the backside of the socket 100 (using dotted lines). When the socket 100 is mounted onto the PCB 300, the recess 104 forms a hollow chamber (e.g. a frame shaped tunnel) for accommodating one or more electrical components 301 which are mounted onto the front side of the PCB 300. The one or more passive components 301 may e.g. be capacitors from the 0201 up to the 0402 series. As such, the one or more passive components 301 can be placed in proximity of the chip 200, thereby reducing the risk of a malfunctioning of the chip 200. In particular, this ensures that the performance of the chip 200 during a test phase (when the chip 200 is connected to the PCB 300 using the socket 100) corresponds (better) to the performance of the chip 200 during operation (when the chip 200 is directly mounted on the PCB 300).

In the present document, a chip socket has been described which is particularly adapted for testing IC chips. The chip socket provides a recess at its backside (i.e. at the side facing a PCB) in order to accommodate one or more electrical components mounted onto the PCB. The recess may be positioned close to the connectors of the chip socket (i.e. close to the connectors of an IC chip placed within the chip socket). As such, a voltage which is generated at the IC chip due to the equivalent series inductance of the electrical conductors between the IC chip and the one or more electrical components, may be reduced. Overall, this allows IC chips to be tested under testing conditions (using a socket) which (more closely) match the actual operational conditions (where the IC chip is directly mounted onto the PCB).

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiment outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

## Claims

1. A chip socket (100) adapted for carrying an integrated circuit chip (200), the chip socket (100) comprising
- a plate (101) adapted for mounting onto a front side of a printed circuit board (300), referred to as a PCB;
- a plurality of electrical PCB connectors (102) in a first area on a backside of the plate (101); wherein the plurality of electrical PCB connectors (102) is adapted for electrically connecting the chip socket (100) to a corresponding plurality of connectors on the PCB (300); and
- a corresponding plurality of chip connectors (103) on a front side of the plate (101); wherein the plurality of chip connectors (103) is electrically connected to the plurality of electrical PCB connectors (102), respectively; wherein the plurality of chip connectors (103) is adapted for connecting the chip socket (100) to a corresponding plurality of connectors (201) of the integrated circuit chip (200);
wherein the plate (101) comprises a recess (104) at its backside between the first area and an edge (106) of the plate (101).

2. The chip socket (100) of claim 1, wherein the recess (104) is positioned closer to an edge of the first area than to the edge (106) of the plate (101).

3. The chip socket (100) of any previous claim, wherein the recess (104) is enclosing the first area.

4. The chip socket (100) of any previous claim, wherein the recess (104) is adapted for accommodating an electrical component (301) mounted onto the front side of the PCB (300).

5. The chip socket (100) of any previous claim, wherein the recess (104) is a groove within the backside of the plate (101).

6. The chip socket (100) of claim 5, wherein the recess (104) is a milling groove.

7. The chip socket (100) of any previous claim, wherein the plurality of chip connectors (103) on the front side of the plate (101) is positioned in the first area.

8. The chip socket (100) of any previous claim, wherein the first area comprises a center position of the plate (101).

9. The chip socket (100) of any previous claim, wherein the plate (101) is rectangular.

10. The chip socket (100) of any previous claim, wherein the plurality of chip connectors (103) and/or the plurality of PCB connectors is any one of: a land grid array, a ball grid array, a pin grid array, JLCC, PLCC, BGA, QFN, CSP, LCC, CSP, CPLL, a pressure sensitive conductive foil.

11. The chip socket (100) of any previous claim, wherein the integrated circuit chip (200) has a standardized chip package.

12. The chip socket (100) of any previous claim, further comprising means for fixing (107) the integrated circuit chip (200) onto the front side of the plate (101) such that the plurality of chip connectors (103) is connected to the corresponding plurality of connectors (201) of the integrated circuit chip (200), when the integrated circuit chip (200) is fixed onto the front side of the plate (101).

13. The chip socket (100) of any previous claim, wherein the plate (101) comprises a removable inset (109) at the first area, wherein the inset (109) comprises the plurality of electrical PCB connectors (102) on a backside of the inset (109) and the plurality of chip connectors (103) on a front side of the inset (109).

14. The chip socket (100) of any previous claim, wherein the backside of the plate (101) is substantially flat, except for the recess (104) and the first area.

15. A printed circuit board (300) comprising a chip socket (100) according to any of claims 1 to 14.
